# EUROPEAN PATENT APPLICATION

(11) **EP 4 753 386 A1**
(43) Date of publication of application: **03.06.2026**
(21) Application number: 25218843.8
(22) Date of filing: 26.11.2025
(51) Int. Cl.: H05K 7/14

(54) **COMPUTING BLOCK SYSTEM**

(30) Priority: 28.11.2024 US 202463726246 P; 22.11.2025 US 202519397868
(71) Applicant: Vertiv Corporation, Westerville, OH 43082 (US)
(72) Inventor: RADANOVIC, Branislav, Westerville, 43082 (US)
(74) Representative: Beal, James Michael

(57) **Abstract**

A modular computing system can include a plurality of computing blocks, a framework for physically supporting the computing blocks, and interconnecting infrastructure. The interconnecting infrastructure can provide the computing blocks with power, cooling, and communications. Each computing block can include an enclosure, a computing section within the enclosure, a cooling section within the enclosure to extract heat from the computing section, power infrastructure to supply power to the computing section, communications infrastructure to facilitate communications between the computing section and an external network, cooling infrastructure to transfer heat from within the enclosure to outside of the enclosure, and a service corridor within the enclosure to provide physical access to at least the computing section.

## Description

### CROSS-REFERENCE TO RELATED APPLICATION(S)

This application claims the benefit of U.S. Provisional Patent Application No. 63/726,246 filed November 28, 2024 and of U.S. Non-Provisional Patent Application No. 19/397,868 filed November 22 2025.

### TECHNICAL FIELD

The present disclosure relates generally to data centers and more specifically relates to modular designs for data centers.

### BACKGROUND

Datacenters come in a variety of forms. Traditional standardization stops at the individual rack level. With the increase of power, cooling and computing requirements, standardized racks are often not even used. This can result in sub-optimal forms or solutions to address specific computing tasks, which can be inefficient in terms of space utilization, interoperability, upgradability, redundancy, and/or other considerations.

### SUMMARY

Applicant has created new and useful devices, systems and methods for designing, assembling, and upgrading data centers. In at least one embodiment, a modular computing system according to the disclosure can improve implementation and sustainment of data centers by providing modular computing blocks, which can be added and/or replaced as desired.

In at least one embodiment, a modular computing system according to the disclosure can include a plurality of computing blocks, a framework for physically supporting the plurality of computing blocks, interconnecting infrastructure, or any combination thereof. In at least one embodiment, the interconnecting infrastructure can provide the computing blocks with power, cooling, communications, or any combination thereof. In at least one embodiment, the interconnecting infrastructure can include power infrastructure for supplying power to each computing block, communications infrastructure for facilitating communications between each computing block and/or an external network, cooling infrastructure for transferring heat from each computing block, such as to an external environment, or any combination thereof.

In at least one embodiment, each computing block can be removably coupled to, or within, the framework and/or the interconnecting infrastructure, such as for repair, replacement, upgrade, or any combination thereof. In at least one embodiment, a first one of the computing blocks can be removed from the framework and replaced with a second one of the computing blocks. In at least one embodiment, the second one of the computing blocks can be identical to the first one of the computing blocks, can be coupled to the same spot in the framework as the first one of the computing blocks, can be coupled to the same interconnecting infrastructure as the first one of the computing blocks, or any combination thereof. In at least one embodiment, the second one of the computing blocks can be different than, such as an upgraded version of, the first one of the computing blocks.

In at least one embodiment, one computing block can include similar computing equipment and/or functionality with respect to another computing block within the framework. In at least one embodiment, one computing block can include different computing equipment and/or functionality with respect to another computing block within the framework.

In at least one embodiment, the framework can independently support each computing block. In at least one embodiment, the framework can independently support the weight of each computing block. In at least one embodiment, the framework can physically support the weight of one or more additional computing blocks in a stacked configuration. In at least one embodiment, the framework can support the computing blocks in alignment with one another. In at least one embodiment, each computing block can be in physical contact with another computing block within the framework. In at least one embodiment, each computing block can be in physical and/or electrical isolation with respect to another computing block coupled to or within the framework.

In at least one embodiment, each computing block can be accessible on opposing sides while coupled to or within the framework, such as a front and rear side, a first end and a second end, etc. In at least one embodiment, the system can include a staircase, integral with or otherwise coupled to the framework for providing access to at least two of the computing blocks, such as those positioned one above the other and/or a walkway, integral with or otherwise coupled to the framework for providing access to at least two of the computing blocks, such as those positioned side-by-side. In at least one embodiment, each computing block can slide vertically and/or horizontally into and/or within the framework.

In at least one embodiment, a computing block according to the disclosure can include an enclosure, a computing section within the enclosure, a cooling section within the enclosure and/or which can extract heat from the computing section, power infrastructure disposed at least partially within the enclosure and/or which can supply power to the computing section, communications infrastructure disposed at least partially within the enclosure and/or which can facilitate communications between the computing section and at least one external network, cooling infrastructure disposed at least partially within the enclosure and/or which can transfer heat from within the enclosure to outside of the enclosure, a service corridor within the enclosure and/or which can provide physical access to the computing section, or any combination thereof.

In at least one embodiment, the enclosure can be or include a frame surrounding the computing section and the cooling section, such as two dimensionally, i.e., on four sides, or three dimensionally, i.e., on all six sides. In at least one embodiment, the frame can completely surround the computing section and the cooling section and/or surround the computing section and the cooling section in three dimensions. In at least one embodiment, the enclosure can include one or more walls enclosing the computing section and the cooling section. In at least one embodiment, the enclosure can include a top wall, a bottom wall, a front wall, a rear wall, a right-side wall, a left-side wall, or any combination thereof. In at least one embodiment, the enclosure can include one or more doors or other access ports through any wall, such as to provide access to the service corridor. In at least one embodiment, the enclosure can include one or more doors or other access ports that replace and/or function as any of the walls.

In at least one embodiment, a computing block according to the disclosure can include one or more power connectors coupled to the enclosure for supplying power to the power infrastructure. In at least one embodiment, the power connector can be coupled to a wall of the enclosure and/or supply power through the wall of the enclosure. In at least one embodiment, the power infrastructure can include one or more busbars, one or more breakers, one or more cables, one or more plugs and/or receptacles, or any combination thereof.

In at least one embodiment, a computing block according to the disclosure can include one or more communications connectors coupled to the enclosure for facilitating communications between the communications infrastructure and the external network and/or another computing block. In at least one embodiment, the communications connector can be coupled to a wall of the enclosure and/or facilitate communications through the wall of the enclosure. In at least one embodiment, the communications infrastructure can include one or more patch panels, one or more network devices, such as hubs, switches and/or routers, one or more network cables, one or more other networking devices and/or components, or any combination thereof.

In at least one embodiment, a computing block according to the disclosure can include one or more cooling connectors coupled to the enclosure for supplying a cooling fluid to the cooling infrastructure. In at least one embodiment, the cooling connector can be coupled to a wall of the enclosure and/or supply the cooling fluid through the wall of the enclosure. In at least one embodiment, a computing block according to the disclosure can include a cooling module which can supply the cooling fluid to the at least one cooling connector and/or transfer heat extracted from the computing section within the enclosure to an environment outside of the enclosure. In at least one embodiment, the cooling module can be coupled to the computing block inside of, outside of, or through the enclosure or portion thereof, such as the frame or a wall. In at least one embodiment, the cooling section and/or the cooling infrastructure within the enclosure can include one or more ducts, one or more fans, one or more heat exchangers, one or more pumps, such as for pumping the cooling fluid through the heat exchanger, plumbing which can circulate the cooling fluid, or any combination thereof.

In at least one embodiment, the service corridor within the enclosure can provide access, within the enclosure, to the computing section, the cooling section, the power infrastructure, the communications infrastructure, the cooling infrastructure, or any combination thereof. In at least one embodiment, the service corridor within the enclosure can be positioned between the computing section and the cooling section. In at least one embodiment, the service corridor within the enclosure can be sized and configured to allow access to the computing section and/or the cooling section, which can be any size and/or configuration required or desired according to an implementation of the disclosure.

In at least one embodiment, the computing section within the enclosure can be sized and configured to receive one or more computing equipment formats, such as standard 19-inch computer equipment racks or any other required equipment format. In at least one embodiment, two or more of such formats can be positioned side-by-side. In at least one embodiment, each format can support one or more mounted computing devices, such as standard 19-inch rack-mounted computing devices, computing devices such as central processing units (CPUs) and/or graphics processing units (GPUs), other required equipment formats, dedicated heat exchangers and/or dedicated cooling devices, or otherwise. In at least one embodiment, the computing block can be, or function as, a standalone data center and/or be integrated with other computing blocks to form larger data centers.

In at least one embodiment, the enclosure size can be that of a freight container or other size standardized on a datacenter level, such as those specified by the International Organization for Standardization in ISO 688 or other sizing requirements, and/or a framework can be used to support each computing block in a manner similar to that used on container ships and/or in warehouses. In at least one embodiment, the enclosure can physically support the weight of one or more additional computing blocks stacked on it.

In at least one embodiment, the enclosure can be removably coupled to, or within, a framework which can support a plurality of enclosures and/or computing blocks. In at least one embodiment, the framework can independently support each enclosure. In at least one embodiment, each enclosure can be accessible on opposing sides while coupled to, or within, the framework, such as a front and rear side, a first end and a second end, etc. In at least one embodiment, the system can include a staircase, integral with or otherwise coupled to the framework for providing access to at least two of the service corridors within the enclosures, such as the service corridors within the enclosures positioned one above the other and/or a walkway, integral with or otherwise coupled to the framework for providing access to at least two of the service corridors within the enclosures, such as the service corridors within the enclosures positioned side-by-side. In at least one embodiment, each enclosure can slide vertically and/or horizontally into or within the framework. In at least one embodiment, each enclosure can be in physical contact with another enclosure within the framework.

### BRIEF DESCRIPTION OF THE DRAWINGS

FIG. 1 is a side elevation view of one of many embodiments of a computing block according to the disclosure.
FIG. 2 is a side elevation view of one of many embodiments of a computing block and a cooling module according to the disclosure.
FIG. 3 is a side elevation view of one of many embodiments of a modular computing system according to the disclosure.
FIG. 4 is a perspective view of one of many embodiments of a modular computing system according to the disclosure.
FIG. 5 is another perspective view of the modular computing system of FIG. 4.
FIG. 6 is still another perspective view of the modular computing system of FIG. 4.
FIG. 7 is a perspective view of another one of many embodiments of a modular computing system according to the disclosure.
FIG. 8 is a perspective view of still another one of many embodiments of a modular computing system according to the disclosure.
FIG. 9 is a perspective view of one of many embodiments of a modular computing system according to the disclosure, showing multiple units.
FIG. 10 is a perspective view of one of many embodiments of a modular computing system according to the disclosure, showing a computing block being moved relative to the framework.
FIG. 11 is a perspective view of one of many embodiments of a modular computing system according to the disclosure, showing a computing block beside the framework.
FIG. 12 is a perspective view of one of many embodiments of a modular computing system according to the disclosure, showing multiple computing blocks disposed in the framework.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Applicant has created new and useful devices, systems and methods for designing, assembling, and upgrading data centers. In at least one embodiment, a modular computing system according to the disclosure can improve implementation and sustainment of data centers by providing modular computing blocks, which can be added and/or replaced as desired or required in accordance with a given implementation of the disclosure.

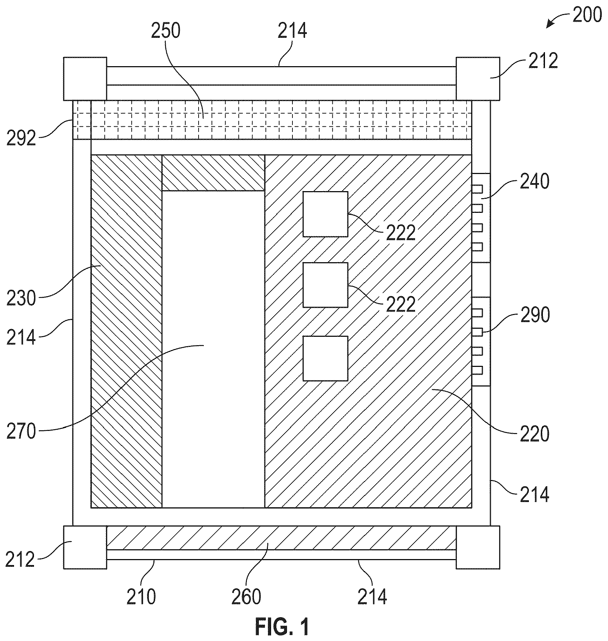

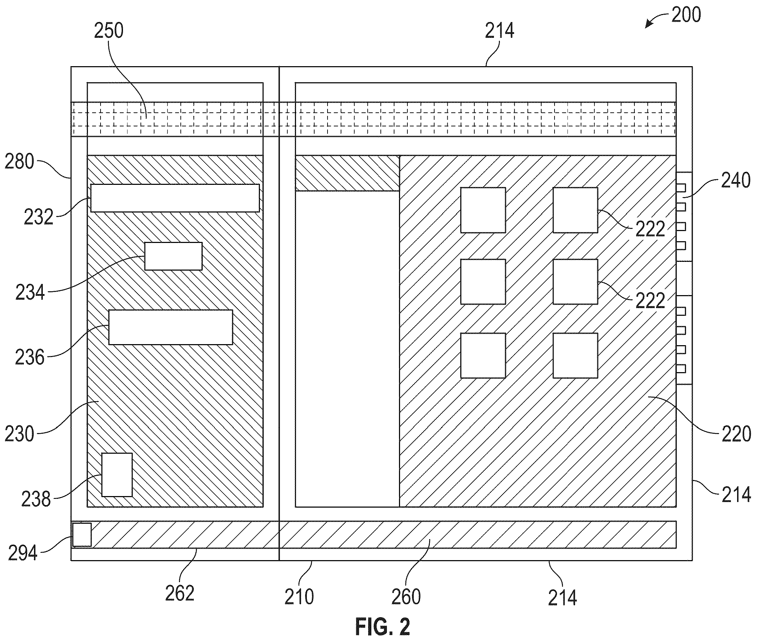

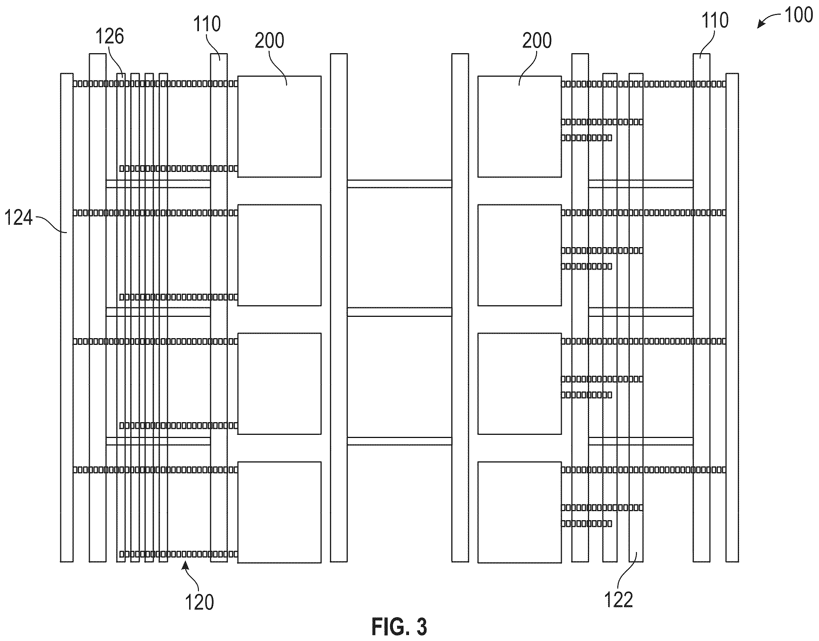

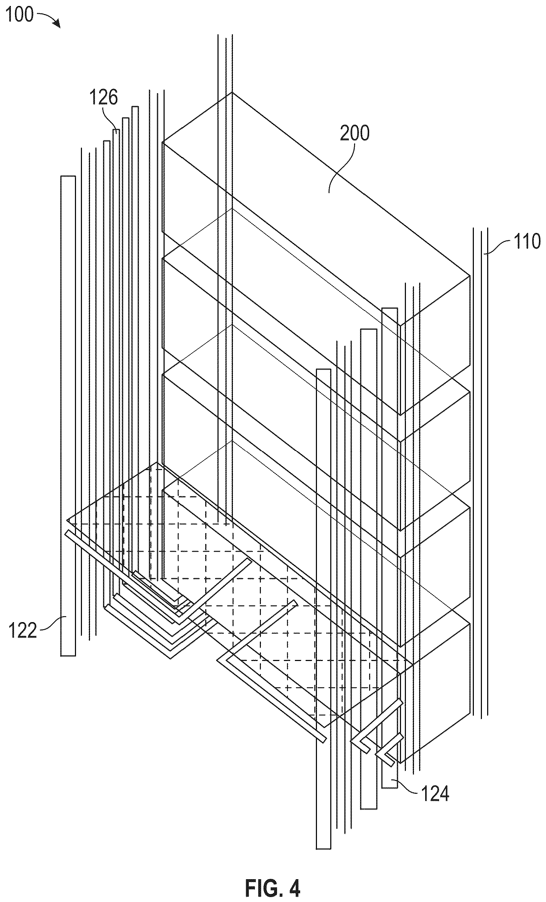

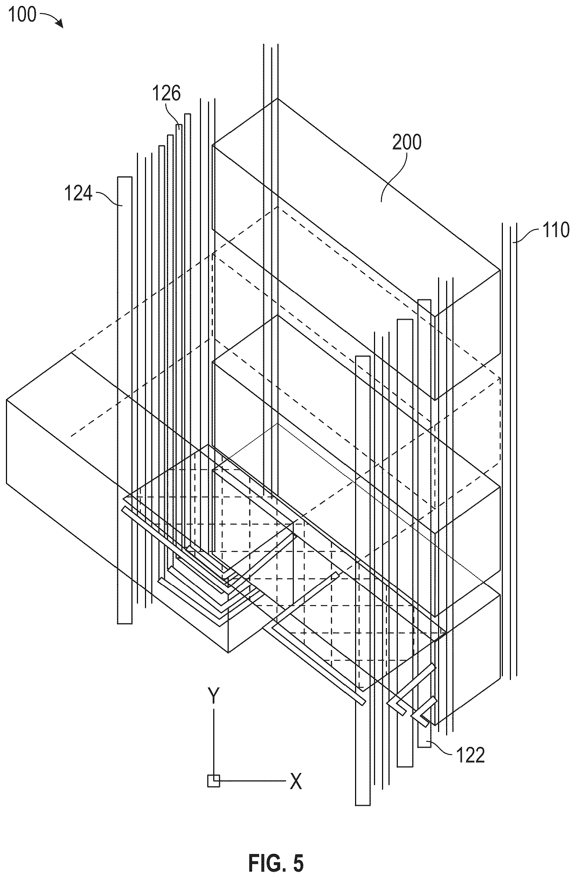

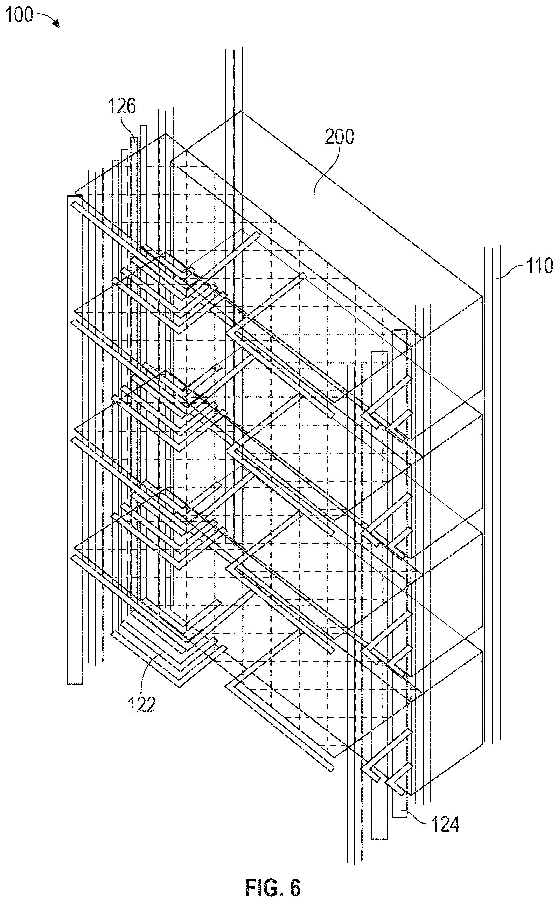

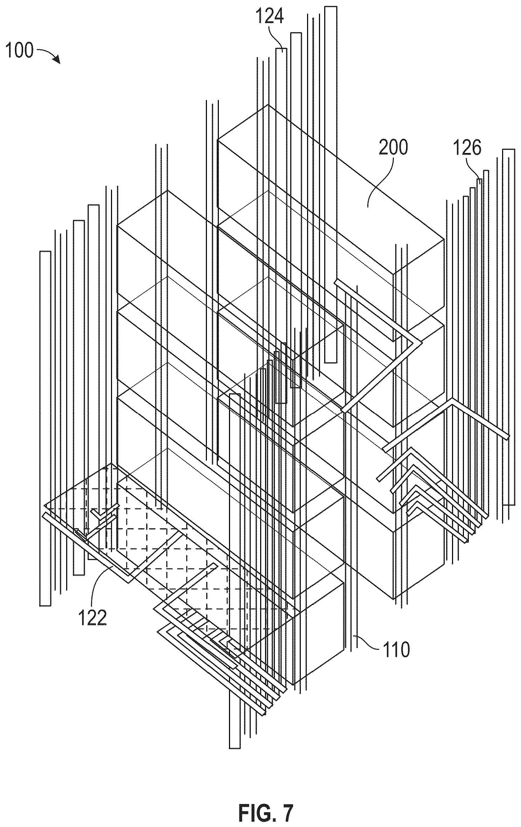

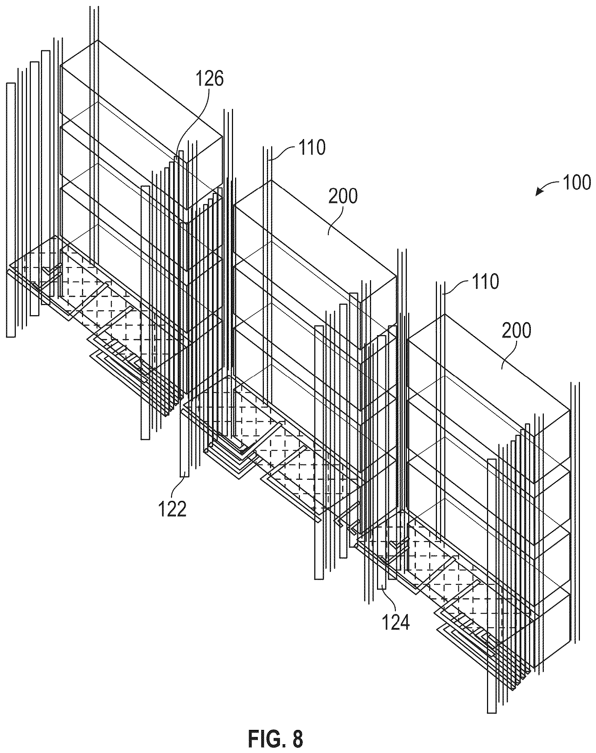

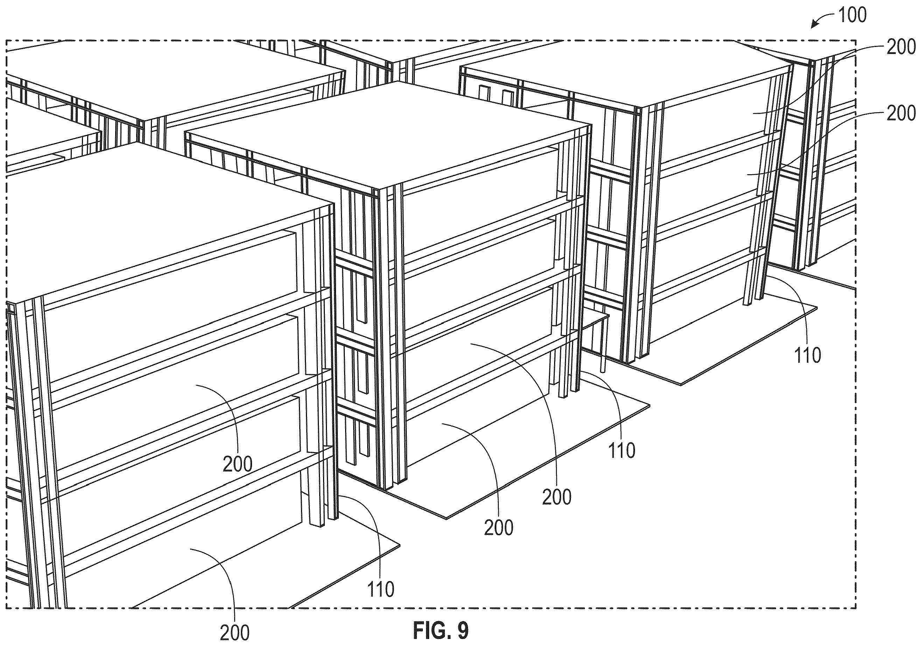

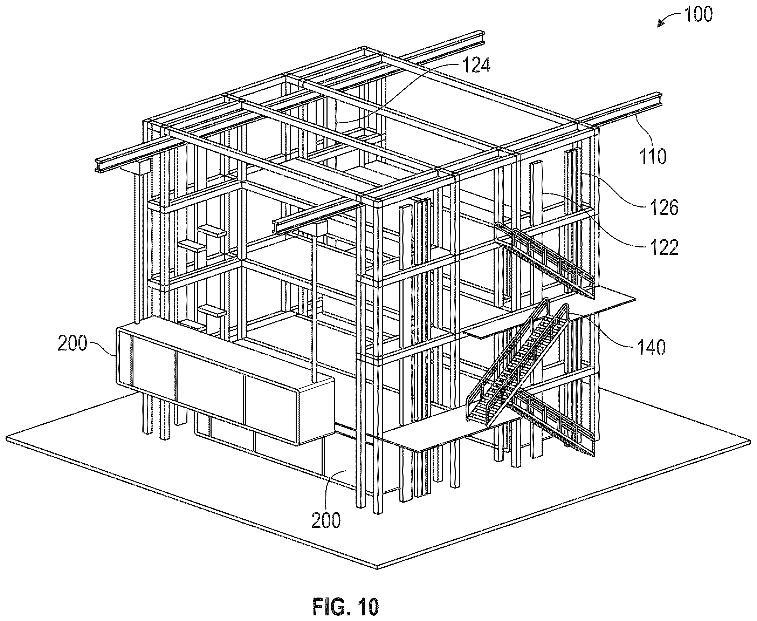

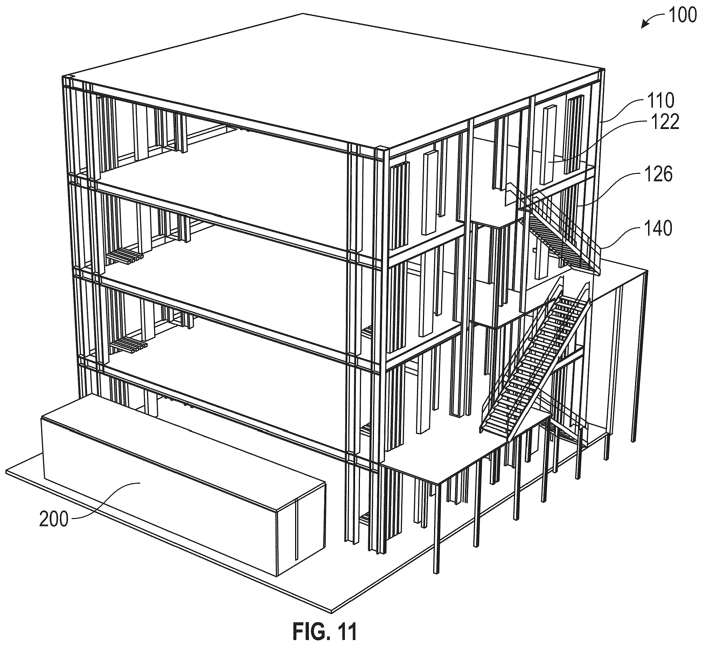

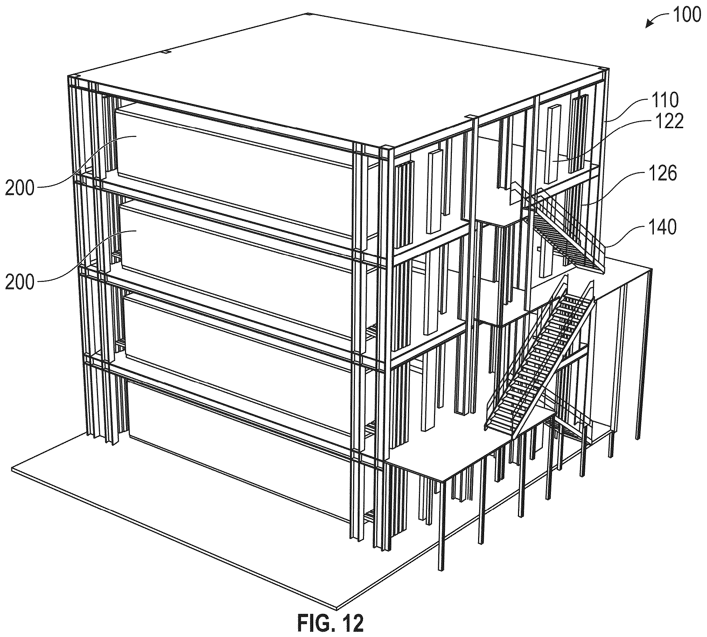

FIG. 1 is a side elevation view of one of many embodiments of a computing block according to the disclosure. FIG. 2 is a side elevation view of one of many embodiments of a computing block and a cooling module according to the disclosure. FIG. 3 is a side elevation view of one of many embodiments of a modular computing system according to the disclosure. FIG. 4 is a perspective view of one of many embodiments of a modular computing system according to the disclosure. FIG. 5 is another perspective view of the modular computing system of FIG. 4. FIG. 6 is still another perspective view of the modular computing system of FIG. 4. FIG. 7 is a perspective view of another one of many embodiments of a modular computing system according to the disclosure. FIG. 8 is a perspective view of still another one of many embodiments of a modular computing system according to the disclosure. FIG. 9 is a perspective view of one of many embodiments of a modular computing system according to the disclosure, showing multiple units. FIG. 10 is a perspective view of one of many embodiments of a modular computing system according to the disclosure, showing a computing block being moved relative to the framework. FIG. 11 is a perspective view of one of many embodiments of a modular computing system according to the disclosure, showing a computing block beside the framework. FIG. 12 is a perspective view of one of many embodiments of a modular computing system according to the disclosure, showing multiple computing blocks disposed in the framework. FIGS. 1-12 are described in conjunction with one another.

In at least one embodiment, a modular computing system 100 according to the disclosure can include a plurality of computing blocks 200, a framework 110 for physically supporting the plurality of computing blocks 200, interconnecting infrastructure 120, or any combination thereof. In at least one embodiment, the interconnecting infrastructure 120 can provide the computing blocks with power, cooling, communications, or any combination thereof. In at least one embodiment, the interconnecting infrastructure 120 can include power infrastructure 122 for supplying power to each computing block 200, communications infrastructure 124 for facilitating communications between each computing block 200 and/or an external network, cooling infrastructure 126 for transferring heat from each computing block 200, such as to an external environment, or any combination thereof.

In at least one embodiment, each computing block 200 can be removably coupled to, or within, the framework 110 and/or the interconnecting infrastructure 120, such as for repair, replacement, upgrade, or any combination thereof. In at least one embodiment, a first one of the computing blocks 200 can be removed from the framework 110 and replaced with a second one of the computing blocks 200. In at least one embodiment, the second one of the computing blocks 200 can be identical to the first one of the computing blocks 200, can be coupled to the same spot in the framework 110 as the first one of the computing blocks 200, can be coupled to the same interconnecting infrastructure 120 as the first one of the computing blocks 200, or any combination thereof. For example, in at least one embodiment, two or more of the computing blocks 200 can be identical or interchangeable in terms of form and interfacing with the framework 110 and interconnecting infrastructure, while either being the same or different in terms of internal configuration and/or function. In at least one embodiment, the second one of the computing blocks 200 can be different than, such as by way of being an upgraded version of, the first one of the computing blocks 200.

In at least one embodiment, one computing block 200 can include similar (which can include identical) computing equipment 222 and/or functionality with respect to another computing block 200 within the framework 110. In at least one embodiment, one computing block 200 can include different computing equipment 222 and/or functionality with respect to another computing block 200 within the framework 110.

In at least one embodiment, the framework 110 can independently support each computing block 200. In at least one embodiment, the framework 110 can independently support the weight of each computing block 200. In at least one embodiment, each computing block 200 and/or framework 110 can physically support the weight of one or more additional computing block 200 stacked on it. In at least one embodiment, the framework 110 can support the computing blocks 200 in alignment with one another. In at least one embodiment, each computing block 200 can be in physical contact with another computing block 200 within the framework 110. In at least one embodiment, each computing block 200 can be in physical and/or electrical isolation with respect to another computing block 200 coupled to or within the framework 110.

In at least one embodiment, each computing block 200 can be accessible on opposing sides while coupled to or within the framework 110, such as a front and rear side, a first end and a second end, etc. In at least one embodiment, the system 100 can include a staircase, integral with or otherwise coupled to the framework 110 for providing access to at least two of the computing blocks 200, such as those positioned one above the other and/or a walkway, integral with or otherwise coupled to the framework 110 for providing access to at least two of the computing blocks 200, such as those positioned side-by-side. In at least one embodiment, each computing block 200 can slide vertically and/or horizontally into and/or within the framework 110.

In at least one embodiment, a computing block 200 according to the disclosure can include an enclosure 210, such as a container or housing, a computing section 220 within the enclosure 210, a cooling section 230 within the enclosure 210 and/or which can extract heat from the computing section 220, power infrastructure 240 disposed at least partially within the enclosure 210 and/or which can supply power to the computing section 220 and/or cooling section 230, communications infrastructure 250 disposed at least partially within the enclosure 210 and/or which can facilitate communications between the computing section 230 and at least one external network and/or another computing block 200, cooling infrastructure 260 disposed at least partially within the enclosure 210 and/or which can transfer heat from within the enclosure 210 to outside of the enclosure 210, a service corridor (or space) 270 within the enclosure 210 and/or which can provide physical access to the computing section 220, cooling section 230, and/or any or all of the infrastructure 240, 250, 260, or any combination thereof.

In at least one embodiment, the enclosure 210 can be or include a frame 212 surrounding the computing section 220 and the cooling section 230, such as two dimensionally, i.e., on four sides or three dimensionally, i.e., on all six sides. In at least one embodiment, the frame 212 can completely surround the computing section 220 and the cooling section 230 and/or surround the computing section 220 and the cooling section 230 in three dimensions. In at least one embodiment, the enclosure 210 can include one or more walls 214 enclosing the computing section 220 and the cooling section 230. In at least one embodiment, the enclosure 210 can include a top wall, a bottom wall, a front wall, a rear wall, a right-side wall, a left-side wall, or any combination thereof. In at least one embodiment, the enclosure 210 can include one or more doors or other access ports through any wall 214, such as to provide access to the service corridor 270. In at least one embodiment, the enclosure 210 can include one or more doors or other access ports that replace and/or function as any of the walls 214.

In at least one embodiment, a computing block 200 according to the disclosure can include one or more power connectors 290 coupled to the enclosure 210 for supplying power to the power infrastructure 240. In at least one embodiment, the power connector can be coupled to a wall 214 of the enclosure 210 and/or supply power through the wall 214 of the enclosure 210. In at least one embodiment, the power infrastructure 240 can include one or more busbars, one or more breakers, one or more cables, one or more plugs and/or receptacles, or any combination thereof.

In at least one embodiment, a computing block 200 according to the disclosure can include one or more communications connectors 292 coupled to the enclosure 210 for facilitating communications between the communications infrastructure 250 and the external network and/or another computing block 200. In at least one embodiment, the communications connector can be coupled to a wall 214 of the enclosure 210 and/or facilitate communications through the wall 214 of the enclosure 210. In at least one embodiment, the communications infrastructure 250 can include one or more patch panels, one or more network devices, such as hubs and/or routers, one or more network cables, one or more other networking devices and/or components, or any combination thereof.

In at least one embodiment, a computing block 200 according to the disclosure can include one or more cooling connectors 294 coupled to the enclosure for supplying a cooling fluid to the cooling infrastructure 260. In at least one embodiment, the cooling connector can be coupled to a wall 214 of the enclosure 210 and/or supply the cooling fluid through the wall 214 of the enclosure 210. In at least one embodiment, a computing block 200 according to the disclosure can include a cooling module 280 which can be connected to the cooling infrastructure 260, such as through the cooling connector, and/or transfer heat extracted from the computing section 220 within the enclosure 210 to an environment outside of the enclosure 210. In at least one embodiment, the cooling module 280 can be coupled to the computing block 200 inside of, outside of, or through the enclosure 210 or portion thereof, such as the frame 212 or a wall 214. In at least one embodiment, the cooling module 280 can work with, replace, or house the cooling section 230, the power infrastructure 240, the communications infrastructure 250, the cooling infrastructure 260, or any combination and/or portion thereof. In at least one embodiment, the cooling section 230, the cooling infrastructure 260, the cooling module 280, or any combination thereof, can include one or more ducts 232, one or more fans 234, one or more heat exchangers 236, one or more prime movers 238 (e.g., pump(s) and/or compressor(s)) for moving the cooling fluid through the heat exchanger, plumbing 262 for circulating, routing and/or controlling flow of the cooling fluid (e.g., fluid conduits, connectors, fittings, valves, and other plumbing components), or any combination thereof.

In at least one embodiment, the service corridor 270 within the enclosure 210 can provide access, within the enclosure 210, to the computing section 220, the cooling section 230, the power infrastructure 240, the communications infrastructure 250, the cooling infrastructure 260, or any combination thereof, such as for maintenance, repair, upgrading, or any combination thereof. In at least one embodiment, the service corridor 270 within the enclosure 210 can be positioned between the computing section 220 and the cooling section 230. In at least one embodiment, the service corridor 270 within the enclosure 210 can be sized and configured as required or desired for accessing the computing section 220 and/or the cooling section 230, such as for maintenance, repair or other purposes.

In at least one embodiment, the computing section 220 within the enclosure 210 can be sized and configured to receive or otherwise cooperate with one or more computing equipment formats, such as standard 19-inch computer equipment racks or any other required or desired equipment format in accordance with an implementation of the disclosure. In at least one embodiment, two or more of such formats can be positioned side-by-side. In at least one embodiment, each format can support one or more mounted computing devices, such as standard 19-inch rack-mounted computing devices, computing devices such as central processing units (CPUs) and/or graphics processing units (GPUs), dedicated heat exchangers and/or dedicated cooling devices, and/or other required or desired equipment formats. In at least one embodiment, two or more of such devices can be positioned one above another. In at least one embodiment, the computing block 200 can be, or function as, a standalone data center and/or can be integrated with one or more other computing blocks 200 to form one or more larger data centers.

In at least one embodiment, the enclosure 210 can be or include a container, such as a freight container or a container of another size standardized on a datacenter level (whether now known or future developed), such as those specified by the International Organization for Standardization in ISO 688 or other sizing requirements, and/or a framework 110 can be arranged for supporting each computing block 200 in a manner similar to that used on container ships and/or in warehouses. In at least one embodiment, the enclosure 210 and/or framework 110 can physically support the weight of one or more additional computing blocks 200, such as one or more blocks 200 stacked on the enclosure 210, on top of the enclosure 210, or otherwise supported by the enclosure 210, and/or in levels of the framework 110.

In at least one embodiment, the enclosure 210 can be removably coupled to, or within, a framework 110 which can support a plurality of enclosures 210 and/or computing blocks 200. In at least one embodiment, the framework 110 can independently support each enclosure 210. In at least one embodiment, each enclosure 210 can be accessible on opposing sides while coupled to, or within, the framework 110, such as a front and rear side, a first end and a second end, or one or more other sides. In at least one embodiment, the system 100 can include a staircase 140 integral with or otherwise coupled to the framework 110 for providing access to at least two of the service corridors 270 within the enclosures 210, such as the service corridors 270 within the enclosures 210 positioned one above the other and/or a walkway, integral with or otherwise coupled to the framework 110 for providing access to at least two of the service corridors 270 within the enclosures 210, such as the service corridors 270 within the enclosures 210 positioned side-by-side. In at least one embodiment, each enclosure 210 can slide vertically and/or horizontally into or within the framework 110. In at least one embodiment, each enclosure 210 can be in physical contact with another enclosure 210 within the framework 110 or be isolated therefrom.

In at least one embodiment, a modular computing system according to the disclosure can include a plurality of computing blocks, a framework for physically supporting the plurality of computing blocks, interconnecting infrastructure, or any combination thereof. In at least one embodiment, the interconnecting infrastructure can provide the computing blocks with power, cooling, communications, or any combination thereof. In at least one embodiment, the interconnecting infrastructure can include power infrastructure for supplying power to each computing block, communications infrastructure for facilitating communications between each computing block and/or an external network, cooling infrastructure for transferring heat from each computing block, such as to an external environment, or any combination thereof.

In at least one embodiment, each computing block can be removably coupled to, or within, the framework and/or the interconnecting infrastructure, such as for repair, replacement, upgrade, or any combination thereof. In at least one embodiment, a first one of the computing blocks can be removed from the framework and replaced with a second one of the computing blocks. In at least one embodiment, the second one of the computing blocks can be identical to the first one of the computing blocks, can be coupled to the same spot in the framework as the first one of the computing blocks, can be coupled to the same interconnecting infrastructure as the first one of the computing blocks, or any combination thereof. In at least one embodiment, the second one of the computing blocks can be different than, such as an upgraded version of, the first one of the computing blocks.

In at least one embodiment, one computing block can include similar computing equipment and/or functionality with respect to another computing block within the framework. In at least one embodiment, one computing block can include different computing equipment and/or functionality with respect to another computing block within the framework.

In at least one embodiment, the framework can independently support each computing block. In at least one embodiment, the framework can independently support the weight of each computing block. In at least one embodiment, each computing block can physically support the weight of one or more additional computing block stacked on it. In at least one embodiment, the framework can support the computing blocks in alignment with one another. In at least one embodiment, each computing block can be in physical contact with another computing block within the framework. In at least one embodiment, each computing block can be in physical and/or electrical isolation with respect to another computing block coupled to or within the framework.

In at least one embodiment, each computing block can be accessible on opposing sides while coupled to or within the framework, such as a front and rear side, a first end and a second end, etc. In at least one embodiment, the system can include a staircase, integral with or otherwise coupled to the framework for providing access to at least two of the computing blocks, such as those positioned one above the other and/or a walkway, integral with or otherwise coupled to the framework for providing access to at least two of the computing blocks, such as those positioned side-by-side. In at least one embodiment, each computing block can slide vertically and/or horizontally into and/or within the framework.

In at least one embodiment, a computing block according to the disclosure can include an enclosure, a computing section within the enclosure, a cooling section within the enclosure and/or which can extract heat from the computing section, power infrastructure disposed at least partially within the enclosure and/or which can supply power to the computing section, communications infrastructure disposed at least partially within the enclosure and/or which can facilitate communications between the computing section and at least one external network, cooling infrastructure disposed at least partially within the enclosure and/or which can transfer heat from within the enclosure to outside of the enclosure, a service corridor within the enclosure and/or which can provide physical access to the computing section, or any combination thereof.

In at least one embodiment, the enclosure can be or include a frame surrounding the computing section and the cooling section, such as two dimensionally, i.e., on four sides or three dimensionally, i.e., on all six sides. In at least one embodiment, the frame can completely surround the computing section and the cooling section and/or surround the computing section and the cooling section in three dimensions. In at least one embodiment, the enclosure can include one or more walls enclosing the computing section and the cooling section. In at least one embodiment, the enclosure can include a top wall, a bottom wall, a front wall, a rear wall, a right-side wall, a left-side wall, or any combination thereof. In at least one embodiment, the enclosure can include one or more doors or other access ports through any wall, such as to provide access to the service corridor. In at least one embodiment, the enclosure can include one or more doors or other access ports that replace and/or function as any of one or more walls.

In at least one embodiment, a computing block according to the disclosure can include one or more power connectors coupled to the enclosure for supplying power to the power infrastructure. In at least one embodiment, the power connector can be coupled to a wall of the enclosure and/or supply power through the wall of the enclosure. In at least one embodiment, the power infrastructure can include one or more busbars, one or more breakers, one or more cables, one or more plugs and/or receptacles, or any combination thereof.

In at least one embodiment, a computing block according to the disclosure can include one or more communications connectors coupled to the enclosure for facilitating communications between the communications infrastructure and the external network and/or another computing block. In at least one embodiment, the communications connector can be coupled to a wall of the enclosure and/or facilitate communications through the wall of the enclosure. In at least one embodiment, the communications infrastructure can include one or more patch panels, one or more network devices, such as hubs and/or routers, one or more network cables, one or more other networking devices and/or components, or any combination thereof.

In at least one embodiment, a computing block according to the disclosure can include one or more cooling connectors coupled to the enclosure for supplying a cooling fluid to the cooling infrastructure. In at least one embodiment, the cooling connector can be coupled to a wall of the enclosure and/or supply the cooling fluid through the wall of the enclosure. In at least one embodiment, a computing block according to the disclosure can include a cooling module which can supply the cooling fluid to the at least one cooling connector and/or transfer heat extracted from the computing section within the enclosure to an environment outside of the enclosure. In at least one embodiment, the cooling module can be coupled to the computing block inside of, outside of, or through the enclosure or portion thereof, such as the frame or a wall. In at least one embodiment, the cooling section and/or the cooling infrastructure within the enclosure can include one or more ducts, one or more fans, one or more heat exchangers, one or more pumps, such as for pumping the cooling fluid through the heat exchanger, plumbing which can circulate the cooling fluid, or any combination thereof.

In at least one embodiment, the service corridor within the enclosure can provide access, within the enclosure, to the computing section, the cooling section, the power infrastructure, the communications infrastructure, the cooling infrastructure, or any combination thereof. In at least one embodiment, the service corridor within the enclosure can be positioned between the computing section and the cooling section. In at least one embodiment, the service corridor within the enclosure can be sized and configured to allow required size of a service corridor, such as while accessing the computing section and/or the cooling section.

In at least one embodiment, the computing section within the enclosure can be sized and configured to receive one or more standard 19-inch rack-mounted computing devices, computing devices such as CPUs and/or GPUs, dedicated heat exchangers and/or dedicated cooling devices, and/or other required or desired equipment and/or formats, such as positioned side-by-side. In at least one embodiment, each rack can support one or more rack-mounted computing devices, such as positioned one above another. In at least one embodiment, the computing block can be, or function as, a standalone data center and/or be integrated with other computing blocks to form larger data centers.

In at least one embodiment, the enclosure can be a freight container, such as those specified by the International Organization for Standardization in ISO 688, and/or a framework can be used to support each computing block in a manner similar to that used on container ships and/or in warehouses. In at least one embodiment, the enclosure can physically support the weight of one or more computing blocks in a stacked configuration. In at least one embodiment, the enclosure can be or includes a container of any size and/or shape, such as a container standardized for datacenter purposes or otherwise.

In at least one embodiment, the enclosure can be removably coupled to, or within, a framework which can support a plurality of enclosures and/or computing blocks. In at least one embodiment, the framework can independently support each enclosure. In at least one embodiment, each enclosure can be accessible on opposing sides while coupled to, or within, the framework, such as a front and rear side, a first end and a second end, etc. In at least one embodiment, the system can include a staircase, integral with or otherwise coupled to the framework for providing access to at least two of the service corridors within the enclosures, such as the service corridors within the enclosures positioned one above the other and/or a walkway, integral with or otherwise coupled to the framework for providing access to at least two of the service corridors within the enclosures, such as the service corridors within the enclosures positioned side-by-side. In at least one embodiment, each enclosure can slide vertically and/or horizontally into or within the framework. In at least one embodiment, each enclosure can be in physical contact with another enclosure within the framework.

Other and further embodiments utilizing one or more aspects of the disclosure can be devised without departing from the spirit of Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other embodiments and not every embodiment of the inventions has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicant, but rather, in conformity with the patent laws, Applicant intends to fully protect all such modifications and improvements that come within the scope or range of equivalents of the following claims.
The disclosure comprises the following items:
1. A modular computing system comprising:
   a plurality of computing blocks, wherein each computing block includes
      an enclosure;
      a computing section within the enclosure;
      a cooling section within the enclosure; and
      a service corridor within the enclosure and configured to provide access to the computing section within the enclosure;
   a framework configured to physically support the plurality of computing blocks; and
   interconnecting infrastructure including
      power infrastructure configured to supply power to each computing block;
      communications infrastructure configured to facilitate communications
   between each computing block; and
      cooling infrastructure configured to transfer heat from each computing block to an external environment.
2. The system as set forth in item 1, wherein each computing block is removably coupled to the framework and the interconnecting infrastructure.
3. The system as set forth in item 1 or item 2, wherein a first one of the computing blocks is configured to be removed from the framework and replaced with a second one of the computing blocks.
4. The system as set forth in any preceding item, wherein each enclosure comprises a frame surrounding the computing section and the cooling section.
5. The system as set forth in any preceding item, wherein each enclosure comprises a frame and a plurality of walls enclosing the computing section and the cooling section.
6. The system as set forth in any preceding item, wherein each enclosure is configured to physically support the weight of at least one additional computing block thereupon and wherein the framework is configured to support the computing blocks in alignment with one another.
7. The system as set forth in any preceding item, wherein each enclosure is of a size that is standardized on a datacenter level.
8. The system as set forth in any preceding item, wherein the service corridor within each enclosure is sized and configured to allow an average man to stand within the service corridor.
9. The system as set forth in any preceding item, wherein the service corridor within each enclosure is positioned at least partially between the computing section and the cooling section.
10. The system as set forth in any preceding item, wherein the service corridor within each enclosure is configured to provide access, within the enclosure, to the computing section and the cooling section.
11. The system as set forth in any preceding item, wherein the computing section within each enclosure is sized and configured to receive a plurality of computing equipment formats.
12. The system as set forth in any preceding item, wherein the cooling section within each enclosure includes at least one duct and at least one fan.
13. The system as set forth in any preceding item, wherein the cooling section within each enclosure includes at least one heat exchanger and at least one pump configured to pump cooling fluid through the at least one heat exchanger and the computing section.
14. The system as set forth in any preceding item, wherein the cooling infrastructure within each enclosure includes plumbing configured to circulate a cooling fluid therein.
15. The system as set forth in any preceding item, wherein each enclosure is configured to slide vertically within the framework.
16. The system as set forth in any preceding item, wherein each enclosure is configured to slide horizontally within the framework.
17. The system as set forth in any preceding item, wherein each enclosure is configured to be in physical contact with another enclosure within the framework.
18. The system as set forth in any preceding item, wherein the framework is configured to independently support each enclosure.
19. The system as set forth in any preceding item, wherein each enclosure is configured to be accessible from a side while coupled within the framework.
20. The system as set forth in any preceding item, further comprising a staircase coupled to the framework and configured to provide access to the service corridor within the enclosure.

## Claims

1. A modular computing system comprising:
a plurality of computing blocks, wherein each computing block includes:
an enclosure;
a computing section within the enclosure;
a cooling section within the enclosure; and
a service corridor within the enclosure and configured to provide access to the computing section within the enclosure;
a framework configured to physically support the plurality of computing blocks;
and
interconnecting infrastructure including:
power infrastructure configured to supply power to each computing block;
communications infrastructure configured to facilitate communications between each computing block; and
cooling infrastructure configured to transfer heat from each computing block to an external environment.

2. The system as set forth in claim 1, wherein each computing block is removably coupled to the framework and the interconnecting infrastructure.

3. The system as set forth in claim 1 or claim 2, wherein a first one of the computing blocks is configured to be removed from the framework and replaced with a second one of the computing blocks.

4. The system as set forth in any preceding claim, wherein each enclosure comprises a frame surrounding the computing section and the cooling section and/or wherein each enclosure comprises a frame and a plurality of walls enclosing the computing section and the cooling section.

5. The system as set forth in any preceding claim, wherein each enclosure is configured to physically support the weight of at least one additional computing block thereupon and wherein the framework is configured to support the computing blocks in alignment with one another.

6. The system as set forth in any preceding claim, wherein each enclosure is of a size that is standardized on a datacenter level and/or wherein the service corridor within each enclosure is sized and configured to allow an average man to stand within the service corridor.

7. The system as set forth in any preceding claim, wherein the service corridor within each enclosure is positioned at least partially between the computing section and the cooling section and/or wherein the service corridor within each enclosure is configured to provide access, within the enclosure, to the computing section and the cooling section.

8. The system as set forth in any preceding claim, wherein the computing section within each enclosure is sized and configured to receive a plurality of computing equipment formats.

9. The system as set forth in any preceding claim, wherein the cooling section within each enclosure includes at least one duct and at least one fan.

10. The system as set forth in any preceding claim, wherein the cooling section within each enclosure includes at least one heat exchanger and at least one pump configured to pump cooling fluid through the at least one heat exchanger and the computing section.

11. The system as set forth in any preceding claim, wherein the cooling infrastructure within each enclosure includes plumbing configured to circulate a cooling fluid therein.

12. The system as set forth in any preceding claim, wherein each enclosure is configured to slide vertically within the framework and/or wherein each enclosure is configured to slide horizontally within the framework.

13. The system as set forth in any preceding claim, wherein each enclosure is configured to be in physical contact with another enclosure within the framework.

14. The system as set forth in any preceding claim, wherein the framework is configured to independently support each enclosure and/or wherein each enclosure is configured to be accessible from a side while coupled within the framework.

15. The system as set forth in any preceding claim, further comprising a staircase coupled to the framework and configured to provide access to the service corridor within the enclosure.
